# EUROPEAN PATENT APPLICATION

(11) **EP 0 980 026 A1**
(43) Date of publication of application: **16.02.2000**
(21) Application number: 99906523.8
(22) Date of filing: 26.02.1999
(51) Int. Cl.: G03F 7/004, C09J 7/02

(54) **DRY IMAGE FORMING MATERIAL AND DRY IMAGE FORMING METHOD**

(30) Priority: 02.03.1998 JP 6621998
(71) Applicant: Cycolor System Co., Ltd., Chiyoda-ku, Tokyo (JP)
(72) Inventor: UCHIBORI, Takahiro-Oriental Photo Ind. Co., Ltd., Kanagawa 254-0065 (JP); HIGUCHI, Tetsuya-Oriental Photo Industrial Co.,Ltd, Kanagawa 254-0065 (JP); SUZUKI, Masao-Oriental Photo Industrial Co., Ltd., Kanagawa 254-0065 (JP); SUGIMOTO, Yoshitaka,Oriental Photo Industrial Co.,, Kanagawa 254-0065 (JP)
(74) Representative: W.P. THOMPSON & CO.
(86) International application number: JP9900941
(87) International publication number: WO9945434

(57) **Abstract**

The object of the present invention is to provide a material for dry-process forming image and a method for dry-process forming image being capable of producing full-color images whose stability is excellent and whose color balance is not destroyed even at a high temperature and in a high humidity. That is, the present invention provides a material for dry-process forming image comprising a support, a photo-sensitive and pressure-sensitive recording layer, a resin layer and an adhesive sheet; wherein the photo-sensitive and pressure-sensitive recording layer, the resin layer and the adhesive sheet are ranged on and from the support; wherein the photo-sensitive and pressure-sensitive recording layer is in a state of single layer or multiple layers; wherein the photo-sensitive and pressure-sensitive recording layer at least contains a microcapsule and a developer; wherein the microcapsule has a photo-curing compound, photoinitiator and a dye precursor in the inner phase thereof; wherein at least one of group consisting of the support and the adhesive sheet is transparent; and provides a method for dry-process forming image comprising an image-wise exposure to the material for dry-process forming image from a transparent side of the support or the adhesive sheet and a development by an application of pressure.

## Description

### Technical Field

The present invention relates to a material for dry-process forming image and a method for dry-process forming image, using, photo-sensitive microcapsules, and more particularly relates to a material for dry-process forming image and a method for dry-process forming image, which provide excellent stability of images after formation thereof.

### Background Art

A method for forming image, which is based on a photo-sensitive encapsulated substance, is well known. In US-A 4,399,209 and 4,440,846 and the like, Mead Corporation discloses a method for forming image by exposure-controlled release of a material for forming image from microcapsules containing a photo-curing composition.

In this method for forming image, a colorless dye precursor substance called leuco dye, which is released in a controlled manner by exposure, reacts with a developer which is present outside the microcapsules to thereby form a dye image.

According to US-A 4,399,209, the system for forming image is characterized as a transfer system for forming image. That is, the agent for forming image is transferred as an exposed pattern to the surface of a developing sheet containing a developer so as to react with the developer to thereby form images. US-A 4,440,846 discloses a "self-contained" system in which a system for forming image and a developer are present on the same support. That is, the agent for image is encapsulated in capsules breakable by pressure, followed by exposure and breakage of the capsules to cause the contact and reaction between the agent for forming image and the developer, so that images are formed on the support. These methods have excellent features as a method for dry-process forming color-image.

According to these materials for forming image, the microcapsule inner phase is cured or made viscous and the release of the dye precursor substance at the time of breakage by pressure is controlled by the exposure so that positive-positive image pattern formation is made conforming to the exposure. In these materials for forming image, a substantially colorless electron-donative compound, which is called leuco dye and which has a lactone, lactam, sultone, spiropyran, ester, or amide structure, is used as dye precursor. When one of these substances contacts with a substance being generally used in non-carbon papers as a developer (,for example, clay, phenol resin or organic acid,), a color develops and dye pattern is formed. Although these materials for forming image provide an excellent full-color system, the problem involved is a possibility that a leuco dye and a developer, which are unreacted, may be always present in the same system after image formation.

Accordingly, the drawback of these materials for forming image is that, if they are left at a high temperature or in a high humidity or allowed to stand for a long period of time, the unreacted leuco dye oozes out of the photo-curing microcapsules and reacts with the remaining active developer to thereby change a maximum density, a fogging density, and so on, and, as a result, the photographic characteristics being different from those immediately after image formation are exhibited.

In particular, the problem is that, when a mixture of three kinds of microcapsules, which develop yellow, magenta, and cyan colors, respectively, is used, since the degrees of change of the three kinds of microcapsules differ, the color balance is consequently destroyed and the tone as a whole becomes blackish to the extent that the whole becomes blackish and initial vivid full-color images are lost.

### Disclosure of Invention

The object of the present invention is to provide a material for dry-process forming image and a method for dry-process forming image in which photographic characteristics of images formed change hardly even if the images are stored for a long period of time or stored at a high temperature or in a high humidity after the images are formed.

The object of the present invention has been achieved by a material for dry-process forming image comprising a support, a photo-sensitive and pressure-sensitive recording layer, a resin layer and an adhesive sheet; wherein the photo-sensitive and pressure-sensitive recording layer, the resin layer and the adhesive sheet are ranged on and from the support; wherein the photo-sensitive and pressure-sensitive recording layer is in a state of single layer or multiple layers; wherein the photo-sensitive and pressure-sensitive recording layer at least contains a microcapsule and a developer; wherein the microcapsule has a photo-curing compound, photoinitiator and a dye precursor in the inner phase thereof; wherein at least one of group consisting of the support and the adhesive sheet is transparent; and has been achieved by a method for dry-process forming image comprising an image-wise exposure to the material for dry-process forming image from a transparent side of the support or the adhesive sheet and a development by an application of pressure.

The material for dry-process forming image of the present invention can be prepared by providing a photo-sensitive and pressure-sensitive recording layer containing microcapsules, which contain in the inner phase thereof at least a photo-curing compound, a photoinitiator, and a dye precursor, and a developer in a state of single layer or multiple layers on a support, further providing a resin layer on the photo-sensitive and pressure-sensitive recording layer, and adhering the adhesive face of an adhesive sheet onto the resin layer by lamination.

Since at least one of the support and adhesive sheet of the material for forming dry-process image of the present invention is transparent, image-wise exposure is made from the transparent side of the support or adhesive sheet. In the case where both of the support and the adhesive sheet are transparent, any side may be exposed to light.

After the image-wise exposure, image formation can be made by development by the application of pressure.

The resin which can be used in the resin layer of the present invention is not particularly limited so long as it can be formed into a film, and preferably it is a water-soluble resin or a latex dispersed in water. Examples of the water-soluble resin, which are not particularly limiting, may include polyvinyl alcohol derivatives such as fully or partially saponified polyvinyl alcohol, acetoacetylated polyvinyl alcohol, sulfonic acid-modified polyvinyl alcohol, olefin-modified polyvinyl alcohol, nitrile-modified polyvinyl alcohol, amide-modified polyvinyl alcohol and pyrrolidone-modified polyvinyl alcohol, cellulose derivatives such as methylcellulose, ethylcellulose, hydroxyethylcellulose and carboxymethylcellulose, starch derivatives such as oxidized starch, etherified starch, dialdehyde starch and esterified starch, casein and gum arabic.

Examples of the resin dispersed in water may include a styrene-butadiene copolymer emulsion, a vinyl acetate-vinyl chloride-ethylene copolymer emulsion, a methacrylate-butadiene copolymer emulsion, a vinylidene chloride emulsion, and so on.

Besides, in the case where the resin layer is adjacent to an opaque adhesive sheet, a pigment may be added, if necessary. The pigment is not particularly limited, and examples of the pigment may include inorganic pigments such as calcium carbonate, zinc oxide, titanium dioxide, silicon dioxide, aluminum hydroxide, barium sulfate, zinc sulfate, talc, kaolin, clay and colloidal silica, and organic pigments such as styrene microballs, nylon powder, polyethylene powder, a urea-formaldehyde resin filler and raw starch particles.

A coating liquid to be used for the lamination of the resin layer of the present invention is generally prepared as an aqueous solution, which, after being stirred and mixed by a homomixer, a ball mill or the like, if necessary, is coated on the photo-sensitive and pressure-sensitive recording layer by a known variable coating method.

The coating weight of the coating liquid for resin layer of the present invention is generally in the range of from 0.1 to 15 g/m² and preferably in the range of from 0.5 to 8.0 g/m², based on dry weight.

The photo-sensitive microcapsules to be used in the present invention can be prepared according to the methods disclosed in the aforesaid US-A 4399209 and 4440846. That is, the photo-sensitive microcapsules contain in the inner phase thereof a photo-curing compound containing a photoinitiator. Typically, these compounds are a photopolymerizable material or a photo-crosslinkable material which thickens or cures by exposure. In addition to the above-mentioned photo-sensitive material, a dye precursor is also incorporated.

Although the photo-curing compound to be used in the present invention is preferably a material being hardenable by a radical addition polymerization or an ionic polymerization, the photo-curing compound is not particularly limited to such a material.

A representative photo-curing compound is an ethylenically unsaturated organic compound. Preferably, these compounds are liquid and have at least one terminal ethylene group per molecule. A further preferred example of the photo-curing material is an ethylenically unsaturated compound having two or more ethylene groups per molecule. Representative examples of these compounds are esters of ethylenically unsaturated acids with polyhydric alcohols such as trimethylolpropane triacrylate and dipentaerythritol hydroxypentaacrylate.

And then, the other examples may include an acrylate prepolymer prepared by a partial reaction between pentaerythritol and acrylic acid or acrylate as well as isocyanate-modified acrylates, methacrylates and itaconates of polyhydric alcohols which are disclosed in US-A 3783151 and 3759809 and others.

The photoinitiator absorbs a chemical ray and generates a free radical being capable of initiating the free radical polymerization of a polymerizable or crosslinkable compound.

It is preferable to use, as the photoinitiator in the present invention, an ionic dye-counter ion compound described in JP-A 62-150242, 64-60606, 3-20260, 3-116043 and others.

Preferred ionic dye-counter ion is a borate of cationic dyes and is the compound represented by the formula (I); 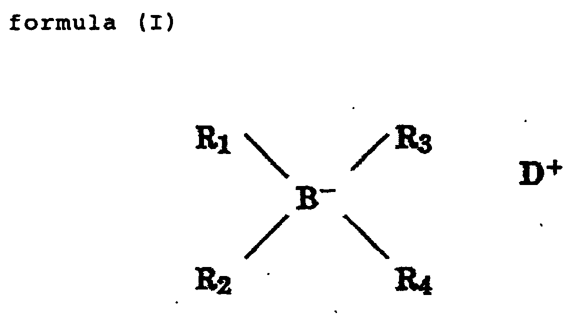 wherein D⁺ represents a cationic dye portion; each of R₁, R₂, R₃ and R₄ represents an alkyl group, an aryl group, an aralkyl group, an alkenyl group, an alkynyl group, a cycloalkyl group, or an allyl group. R₁, R₂, R₃, and R₄ may be same as or different from each other.

Useful dyes can form a photo-reductive complex with a borate anion and are cationic methine, polymethine, triarylmethane, indoline, thiazine, oxazine and acridine dyes. More preferably, the dyes are cationic cyanine, carbocyanine, hemicyanine, rhodamine and azomethine dyes.

Useful cationic dyes are the cyanine dyes represented by the following formula (II); 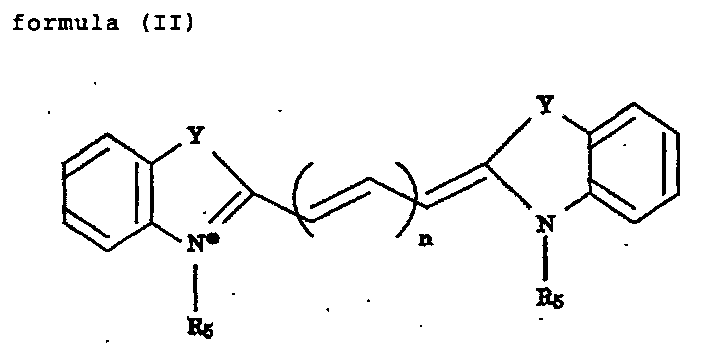 wherein n is 0, 1, 2 or 3; R₅ represents an alkyl group; and Y represents CH=CH, N-CH₃, C(CH₃)₂, O, S or Se.

In the borate anion, it is preferable that at least 1 to 3 of R₁, R₂, R₃, and R₄ are alkyl groups. The alkyl group has 20 or less carbon atoms and more preferably 1 to 7 carbon atoms. It is preferable that R₁, R₂, R₃, and R₄ are a combination of an alkyl group and an aryl group or an aralkyl group and more preferably a combination of 3 aryl groups and 1 alkyl group (for example, triphenylbutyl borate).

And then, other examples may include diarylketone derivatives, polycyclic quinone, benzoin alkyl ether, alkoxyphenylketone, o-acylated oxyiminoketone, phenanthrenequinone, benzophenone, substituted benzophenone, xanthone, thioxanthone, and halides such as chlorosulfonyl or chloromethyl polynuclear aromatic compounds, chlorosulfonyl or chloromethyl heterocyclic compounds, chlorosulfonyl or chloromethylbentophenone, fluorenone, and haloalkanes, as disclosed in JP-A 5-224426.

Examples of the dye precursor to be used in the present invention may include a colorless electron-donative compound. Representative examples of this compound may include a substantially colorless compound which has a lactone, lactam, sultone, spiropyran, ester, or amide structure in the partial skeleton thereof. For examples, they may be triarylmethane compounds, bisphenyl methane compounds, xanthene compounds, fluoran compounds, thiazine compounds or spiropyran compounds. Next, specific examples of dye precursors, which develop yellow, magenta and cyan colors, are given.

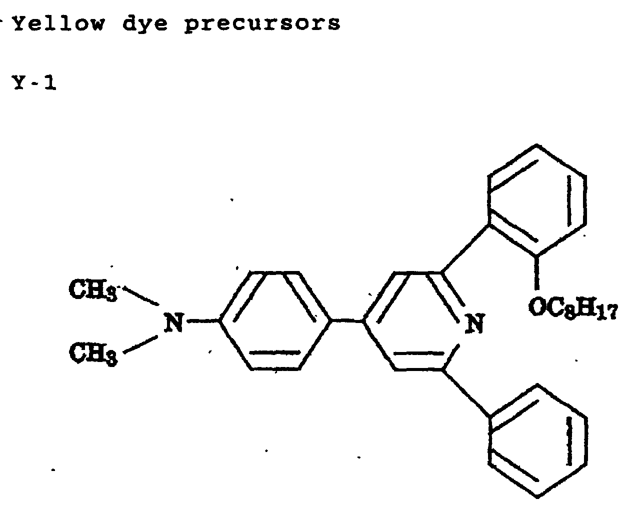

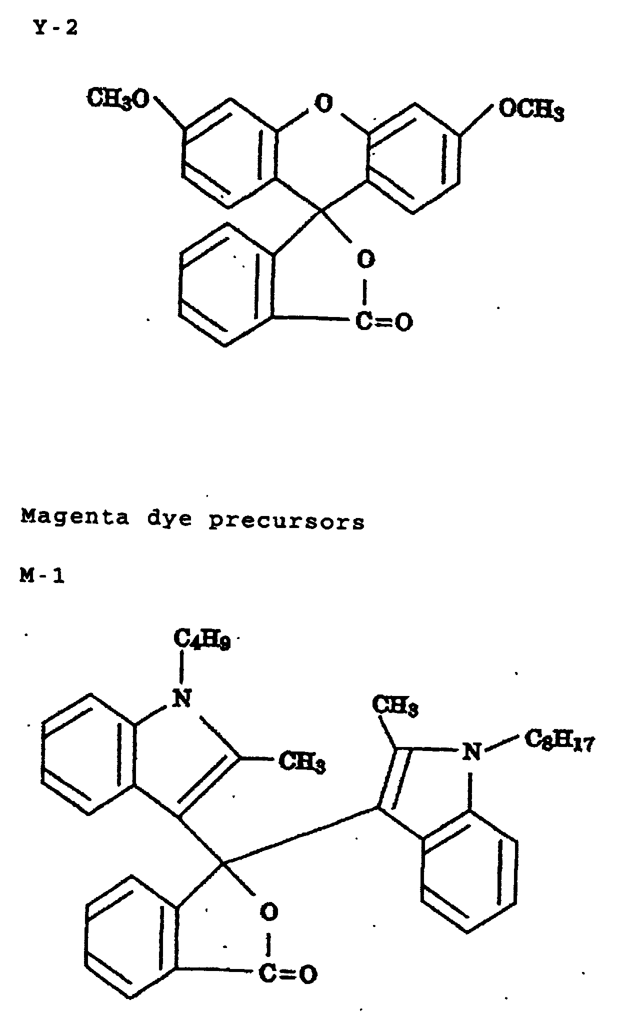

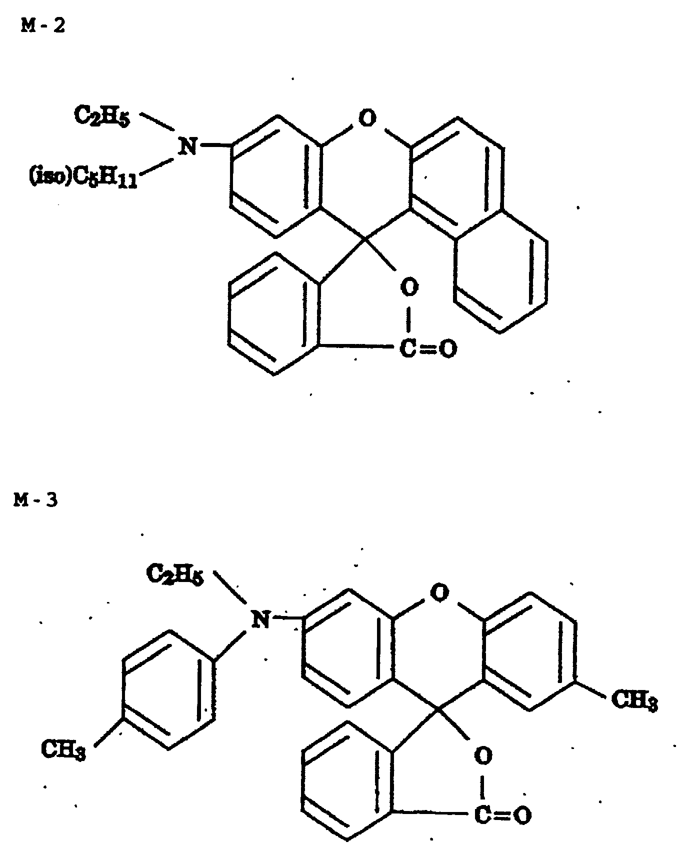

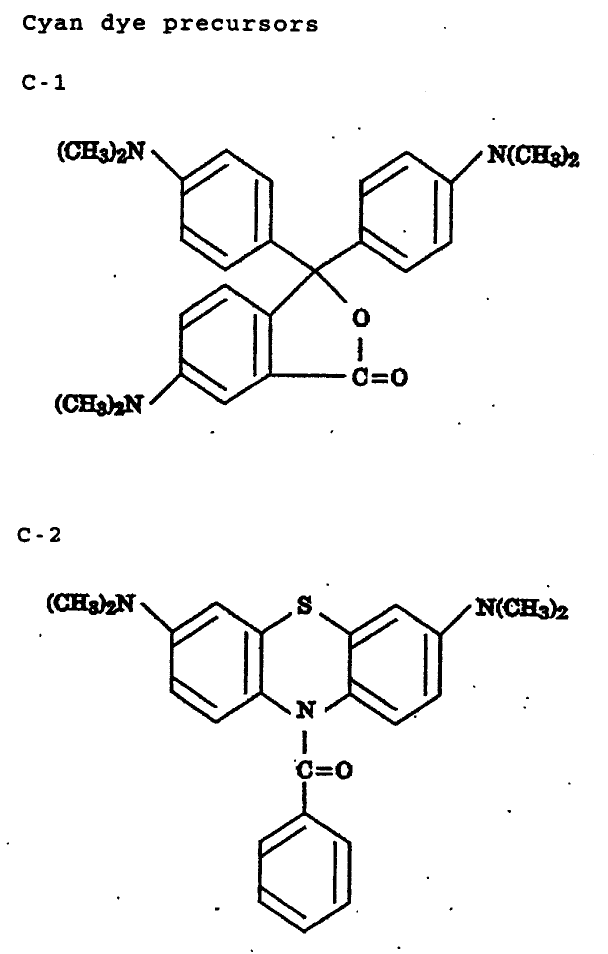

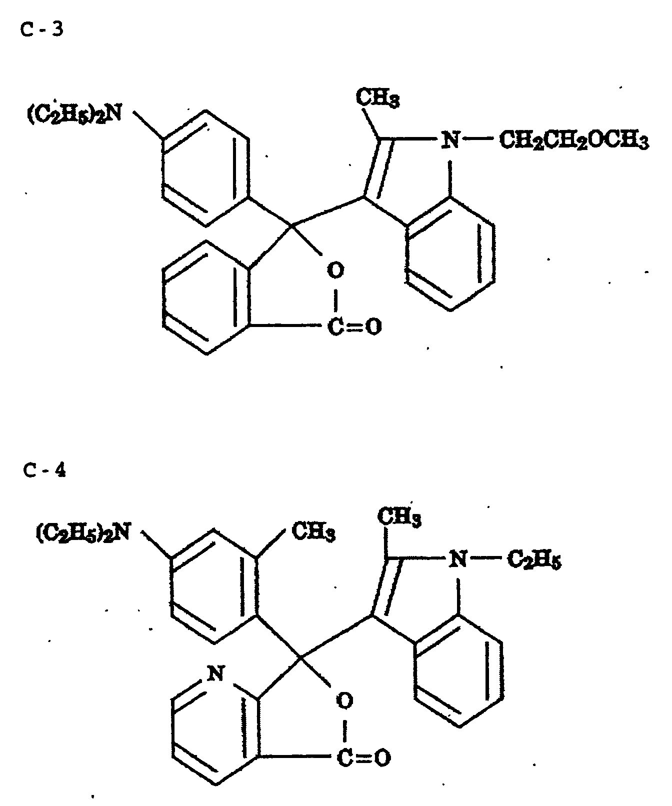

The photo-sensitive microcapsules to be used in the present invention may be used, as sensitizers to improve photo-sensitivity, for example, N,N-dialkylaniline, which are described in JP-A 62-18537 and 64-91130 and defined as autoxidation agents, disulfide compounds such as 2,2'-dibenzothiazolyl disulfide described in JP-A 2-291561, and thiol compounds described in JP-A 2-868.

Discontinuous-walled microcapsules to be used for the encapsulation of the inner phase of the present invention can be prepared by known capsule forming methods which include coacervation, interfacial polymerization, polymerization of one or more monomers in oil, and so on.

Representative examples of a suitable capsule wall forming material may include gelatinous materials including gum arabic, polyvinyl alcohol, and carboxymethylcellulose (US-A 2730456 and 2800457), resorcinol-formaldehyde capsule wall forming agents (US-A 3755190), isocyanate wall forming agents (US-A 3914511), isocyanate-polyol wall forming agents (US-A 3796669), urea-formaldehyde capsule wall forming agents, particularly urea - resorcinol - formaldehydes whose lipophilicity is strengthened by the addition of resorcinol (US-A 4001140), and melamine-formaldehyde and hydroxypropylcellulose (US-A 4025455).

The average particle diameter of the microcapsules to be used in the present invention is preferably in the range of from 1 to 25µm. As to the capsule size, although capsule diameters are preferably small and uniform from the standpoint of photographic characteristics such as resolving power, it is preferable to adjust the particle diameter of the microcapsules to 3 to 15µm and particularly to 3 to 10µm by taking into account the ease of rupture by the application of pressure and the troubles such as disappearance into the pores or fibers of support.

The microcapsules may be mixed with a dispersion liquid of a developer and the mixture may be coated on a paper or film support to thereby form a photo-sensitive and pressure-sensitive recording layer. In this case, a suitable binder such as polyvinyl alcohol, a styrene-butadiene latex. Although microcapsules and the dispersion liquid of a developer can be mixed at any ratio of between 2/8 and 8/2 based on the weight of solid components, a particularly preferred mixing ratio is between 4/6 and 6/4. It is possible to prepare a photo-sensitive and pressure-sensitive recording layer by coating the microcapsules on a paper or film support by using a suitable binder such as polyvinyl alcohol, a styrene-butadiene emulsion and thereafter laminating thereto a dispersion liquid of a developer. Further, it is also possible to prepare a photo-sensitive and pressure-sensitive recording layer by coating the dispersion liquid of the developer on the support and thereafter laminating thereto the dispersion liquid of the microcapsules.

The developer can be selected from developers generally used in non-carbon paper. Specific examples of the developer may include acid clay, active clay, attapulgite, organic acids, for example, tannic acid, gallic acid, and aromatic carboxylic acids, such as benzoic acid, salicylic acid, and 3,5-di-(α-methylbenzyl) salicylic acid, salts of these acids with polyvalent metals, for example, zinc salts, aluminum salts, magnesium salts, phenol resins, for example, phenol formaldehyde resins and phenol acetylene resins and salts of these phenol resins with polyvalent metals. In addition, phenol-salicylic acid-formaldehyde condensation products available as HRJ-4250 and HRJ-4542 manufactured by Schenectady Chemical Co., Ltd. are also useful. Particularly preferred developers are aromatic carboxylic acids or polyvalent metal salts thereof and phenol resins or polyvalent metal salts thereof. These developers may be used as a mixture of two or more of them.

A plastic sheet or a glass plate is useful as the transparent support to be used in the present invention. Examples of the plastic may include polyester, polyethylene, polypropylene, cellulose esters (for example, acetylcellulose), polyvinyl acetal, polystyrene, polycarbonate, polyethylene terephthalate and polyimide.

Examples of the opaque support to be used in the present invention may include general paper such as glassine paper, fine paper, art paper, and the like, plastic sheets such as polyethylene, polypropylene, polyethylene terephthalate and polyamide, synthetic paper or nonwoven fabrics made from these synthetic fibers, laminated paper produced by laminating a synthetic resin to one side or both sides of paper, metal foils, a combination of a metal foil and paper, vapor-deposited paper, an opaque sheet after a hologram treatment, an article produced by lamination of a synthetic film, mica paper and glass plate. These plastic sheets or synthetic resins can be opacified by an inorganic or organic pigment.

The adhesive agent may be selected from among a thermoplastic type, a thermosetting type, a rubber type emulsion, a solvent type, a solventless type and a hot-melt type. A tackifier, a softener, a filler, a releasing agent, a pigment, an ultraviolet absorber, and the like may be added to the adhesive agent, if necessary.

Examples of the adhesive agent may include polyacrylate, acryl copolymers, vinyl chloride-vinyl acetate copolymers, polyvinyl butyral, polyvinyl isobutyl ether, polyvinyl alcohol, natural rubber, butyl rubber, polyisoprene rubber, regenerated rubber, chloroprene, polyisobutylene, silicone rubber and chlorinated rubber, chlorinated butyl.

The adhesive sheet to be used in the present invention can be prepared by coating the above-mentioned adhesive agent on the above-said opaque or transparent support.

The present invention will now be explained more specifically by the following examples, but the present invention is not limited solely to these examples.

### EXAMPLES

### Example 1

### I Preparation of photo-sensitive microcapsules

### Preparation of magenta microcapsules

Photo-sensitive microcapsules were prepared by referring to the examples described in JP-A 2-298340.

### A. Preparation of inner phase

① 105 g of trimethylolpropane triacrylate (TMPTA) and 45 g of dipentaerythritol hydroxypentaacrylate (DPHPA) were placed in a beaker and the mixture was heated at about 105°C for 30 minutes.
② While being stirred, the mixture was added with 20 g of a dye precursor (M-1) and the dye precursor was dissolved. Further, the mixture was stirred at 105°C for 30 minutes, followed by gradual cooling to 70°C.
③ While being stirred, the mixture was added with 0.5 g of a photoinitiator (1,1'-di-n-heptyl-3,3,3',3'-tetramethylindocarbocyanine-triphenyl-n-butyl borate) and the mixture was stirred at 70°C for 30 minutes.
④ While being stirred, the mixture was added with 1.0 g of DIDMA (2,6-diisopropyl-N,N-dimethylaniline) and the mixture was stirred for 5 minutes.
⑤ The mixture was added with 0.5 g of 2,2'-dibenzothiazolyl disulfide and stirred for 20 minutes.
⑥ The mixture was added with 10 g of polyisocyanate (trade name: DURANATE 24A-90PX manufactured by Asahi Chemical Industry Co., Ltd.) and the mixture was kept at 70°C.

### B. Preparation of outer phase

① 430 g of deionized water was placed in a beaker and was stirred at 500 rpm by an overhead mixer.
② 8.0 g of sulfonated polystyrene (trade name: Versa-TL-502 manufactured by National Starch Corporation) was added gradually to the water and the mixture was stirred at 500 rpm for further 15 minutes.
③ 12.65 g of pectin and 0.24 g of sodium hydrogencarbonate were mixed together and the mixture was added to the above-described mixture which was stirred at a stirring speed adjusted to 1500 rpm and the resulting mixture was further stirred at 1500 rpm for 2 hours.
④ The pH value of the mixture was adjusted to 6.0 by using NaOH and the mixture was further stirred at 3000 rpm for 10 minutes.

### C. Emulsification of the inner phase in the outer phase

① The inner phase was added gradually to the outer phase over a period of about 30 seconds.
② The mixture was stirred for emulsification at 3000 rpm for 15 minutes and thus an emulsion was formed.

### D. Preparation of melamine-formaldehyde outer wall

① 250 g of deionized water was placed in a beaker and 22.2 g of melamine was added gradually to the water which was stirred.
② 36.5 g of 37% formaldehyde was added gradually.
③ The mixture was heated to 60°C over a period of about 30 minutes and curing was carried out at 60°C for 60 minutes (formation of a melamine-formaldehyde precondensation product).
④ The melamine-formaldehyde precondensation product was poured into the emulsion of C after adjusting the stirring speed for emulsification to 1,500 rpm.
⑤ The pH was adjusted to 6.0 by using H₃PO₄.
⑥ Then, curing was carried out at 70°C for further 60 minutes and thus microcapsules containing the inner phase were formed.
⑦ 46.2 g of a 25% aqueous solution of urea was added and curing was carried out for 60 minutes.
⑧ The stirring speed was adjusted to 500 rpm and 10 g of a 20% aqueous solution of NaOH was added, and then the mixture was cooled to room temperature.
⑨ The mixture was stirred overnight continuously at room temperature and thus a microcapsule dispersion liquid (A) was obtained.

The particle diameters of the microcapsules obtained were 2 to 12µm and most of them were 6 to 7µm. The concentration of solid components was measured by an electronic water content meter manufactured by Shimadzu Corporation and was found to be 25.2 % by weight.

### Preparation of cyan microcapsules

A microcapsule dispersion liquid (B) was obtained by the same preparation procedure as that for the magenta microcapsules, except that 20 g of C-3 was added in place of the dye precursor (M-1) and the photoinitiator was changed to 0.85 g of 1,1'-di-n-heptyl-3,3,3',3'-tetramethylindodicarbocyanine-triphenyl-n-butyl borate. The particle diameters of the microcapsules obtained were 2 to 12µm and most of them were 6 to 7µm. The concentration of solid components was 26.5 % by weight.

### Preparation of yellow microcapsules

A microcapsule dispersion liquid (C) was obtained by the same preparation procedure as that for the magenta microcapsules, except that the dye precursor was changed to 17.0 g of Y-1 and the photoinitiator was changed to 0.8 g of 3,3-dimethyl-1-heptylindo-3'-heptylthiacyanine-triphenyl-n-butyl borate. The particle diameters of the microcapsules obtained were 5 to 10µm and most of them were 6 to 8 µm. The concentration of solid components was 26.8 % by weight.

### II Preparation of photo-sensitive liquid and coating thereof

A photo-sensitive liquid (I) was obtained by mixing the microcapsule dispersion liquids obtained in I, the developer HRJ-4250 (trade name, manufactured by Schenectady Chemical Co., Ltd.) described in JP-A 1-168484 and 2-95884, and polyvinyl alcohol (trade name: GOHSENOL GM-14, manufactured by Nippon Synthetic Chemical Industry Co., Ltd.), according to the following formulation.

| | |
|---|---|
| Microcapsule dispersion liquid (A) | 6.0 g |
| Microcapsule dispersion liquid (B) | 6.8 g |
| Microcapsule dispersion liquid (C) | 5.3 g |
| HRJ-4250(content of solid components:40% by weight) | 18.2 g |
| GOHSENOL GM-14 (10% by weight aqueous solution) | 2.0 g |
| Deionized water | 11.7 g |

The photo-sensitive liquid (I) thus prepared was coated on a transparent PET film having a thickness of 75µm and dried to thereby form a photo-sensitive and pressure-sensitive recording layer. The coating weight after drying was 13.5 g/m².

An 8% aqueous solution of polyvinyl alcohol (trade name: PVA117, manufactured by Kuraray Co., Ltd.) was coated on the photo-sensitive and pressure-sensitive recording layer and dried so that a coating weight after drying of 5 g/m² was obtained to thereby provide a resin layer.

Sample (I) of the present invention was prepared by laminating an adhesive film for word-processor (trade name: White WT325W manufactured by Plus Co., Ltd.) as an opaque adhesive film onto the polyvinyl alcohol resin layer to thereby form a sandwich-structure with the PET film.

For the purpose of comparison, Sample (II) was prepared in the same manner as that employed in the preparation of Sample (I), except that the adhesive film for word-processor was laminated to the photo-sensitive and pressure-sensitive layer without the formation of the resin layer.

By using a halogen lamp as a light source, Samples (I) and (II) thus prepared were exposed to light from the transparent PET film side using a step tablet. Subsequently, the samples (I) and (II) were subjected to development by the application of pressure using pressure nip rollers and thus positive-positive images were obtained. The density of the images was measured using a Macbeth densitometer. The images obtained were wrapped in a black paper bag and left in an incubator adjusted to 50°C and 70% relative humidity for 3 days to carry out a forced storage test. After that, the images were taken out of the incubator and the density of the images was measured using a Macbeth densitometer. The results are shown in Table 1. The step tablet used here was a step-wise wedge having 30 steps. The step numbers shown in the table range from step 1 of a minimum density region to step 30 of a maximum density region. In the table, initial characteristics indicate the characteristics immediately after image formation; characteristics after forced storage indicate the characteristics after being left in the incubator; Dmax indicates a maximum density; Dmin indicates a minimum density; D₁₅ indicates the density of the 15th step of the step tablet; and filters indicate those used in the Macbeth densitometer, i.e., R stands for red filter, G for green filter, and B for blue filter (the same applies to the tables that follow).

**Table 1**

| SAMPLE NO. | FILTER | INITIAL CHARACTERISTICS | | | CHARACTERISTICS AFTER FORCED STORAGE | | |
|---|---|---|---|---|---|---|---|
| | | Dmax | Dmin | D₁₅ | Dmax | Dmin | D₁₅ |
| (I) (PRESENT INVENTION) | R | 1.77 | 0.23 | 0.66 | 1.80 | 0.24 | 0.68 |
| | G | 1.73 | 0.20 | 0.62 | 1.74 | 0.22 | 0.65 |
| | B | 1.60 | 0.19 | 0.57 | 1.62 | 0.20 | 0.60 |
| (II) (COMPARISON) | R | 1.79 | 0.24 | 0.65 | 1.92 | 0.36 | 0.95 |
| | G | 1.70 | 0.22 | 0.63 | 1.93 | 0.42 | 0.97 |
| | B | 1.62 | 0.20 | 0.59 | 1.83 | 0.34 | 0.88 |

As shown in Table 1, whereas Sample (II) for comparison exhibited variations in image characteristics by increase in all of maximum density, minimum density, and density of intermediate regions after forced storage of the images formed, Sample (I) of the present invention exhibited excellent image stability.

### Example 2

Sample (III) was prepared in the same manner as that employed in the preparation of the Sample (I) in Example 1, except that the polyvinyl alcohol as resin for the resin layer was replaced by a styrene-butadiene latex (48.1% by weight) (trade name: L-1876, manufactured by Asahi Chemical Industry Co., Ltd.), which was diluted to 10%, coated and dried so that a coating weight after drying of 5 g/m² was obtained. With the sample, exposure and development, density measurement of initial images, forced storage, and density measurement after forced storage were conducted in the same manner as Example 1. The results are shown in Table 2.

**Table 2**

| SAMPLE NO. | FILTER | INITIAL CHARACTERISTICS | | | CHARACTERISTICS AFTER FORCED STORAGE | | |
|---|---|---|---|---|---|---|---|
| | | Dmax | Dmin | D₁₅ | Dmax | Dmin | D₁₅ |
| (III) (PRESENT INVENTION) | R | 1.70 | 0.22 | 0.63 | 1.72 | 0.23 | 0.65 |
| | G | 1.69 | 0.21 | 0.60 | 1.70 | 0.23 | 0.61 |
| | B | 1.57 | 0.19 | 0.55 | 1.60 | 0.21 | 0.58 |

As shown in Table 2, Sample (III) of the present invention exhibited excellent image stability because the change in density after the forced storage was small.

### Example 3

An opaque PET film having a thickness of 75µm and containing titanium oxide kneaded thereinto was coated with the photo-sensitive liquid (I) of Example 1 to thereby form a photo-sensitive and pressure-sensitive layer. The coating weight after drying was 13.5 g/m². An 8% aqueous solution of polyvinyl alcohol (trade name: PVA117, manufactured by Kuraray Co., Ltd.) was coated on the photo-sensitive and pressure-sensitive recording layer and dried so that a coating weight after drying of 5 g/m² was obtained to thereby provide a resin layer.

Sample (IV) of the present invention was prepared by laminating a transparent adhesive film (trade name: Ink Jet Printer Label, Transparent Film Label, manufactured by A-one Co., Ltd.) onto the polyvinyl alcohol resin layer to thereby form a sandwich-structure with the PET film.

By using a halogen lamp as a light source, Sample (IV) was exposed to light from the transparent adhesive film side using a step tablet in the same manner in Example 1. Then, after development by the application of pressure, images were obtained. The density of the images was measured using a Macbeth densitometer. Further, the images obtained were subjected to forced storage in the same manner as Example 1, and density was measured. The results are shown in Table 3.

**Table 3**

| SAMPLE NO. | FILTER | INITIAL CHARACTERISTICS | | | CHARACTERISTICS AFTER FORCED STORAGE | | |
|---|---|---|---|---|---|---|---|
| | | Dmax | Dmin | D₁₅ | Dmax | Dmin | D₁₅ |
| (IV) (PRESENT INVENTION) | R | 1.68 | 0.21 | 0.59 | 1.70 | 0.22 | 0.61 |
| | G | 1.65 | 0.20 | 0.60 | 1.68 | 0.22 | 0.62 |
| | B | 1.50 | 0.17 | 0.53 | 1.52 | 0.19 | 0.54 |

As shown in Table 3, Sample (IV) of the present invention exhibited excellent image stability because the change in density after the forced storage was small.

### Industrial Applicability

The present invention made it possible to provide a material for dry-process forming image and a method for dry-process forming image, being capable of producing full-color images in which the change in image characteristics is small and a color balance is not destroyed even at a high temperature and in a high humidity.

## Claims

1. A material for dry-process forming image comprising a support, a photo-sensitive and pressure-sensitive recording layer, a resin layer and an adhesive sheet; wherein the photo-sensitive and pressure-sensitive recording layer, the resin layer and the adhesive sheet are ranged on and from the support; wherein the photo-sensitive and pressure-sensitive recording layer is in a state of single layer or multiple layers; wherein the photo-sensitive and pressure-sensitive recording layer at least contains a microcapsule and a developer; wherein the microcapsule has a photo-curing compound, photoinitiator and a dye precursor in the inner phase thereof; and wherein at least one of group consisting of the support and the adhesive sheet is transparent.

2. The material for dry-process forming image as claimed in Claim 1, wherein the support is a transparent support and the adhesive sheet is an opaque adhesive sheet or a transparent adhesive sheet.

3. The material for dry-process forming image as claimed in Claim 1, wherein the support is an opaque support and the adhesive sheet is a transparent adhesive sheet.

4. The material for dry-process forming image as claimed in Claim 1, wherein the resin of the resin layer is a water-soluble resin or a water-dispersed resin.

5. The material for dry-process forming image a claimed in Claim 1, wherein the photo-curing compound is a radical addition-polymerizable substance.

6. The material for dry-process forming image as claimed in Claim 1, wherein the photoinitiator is an initiator which absorbs a chemical ray and generates a free radical capable being of initiating a free radical polymerization of a polymerizable or crosslinkable compound.

7. The material for dry-process forming image as claimed in Claim 6, wherein the photoinitiator is a compound represented by the following formula (I); 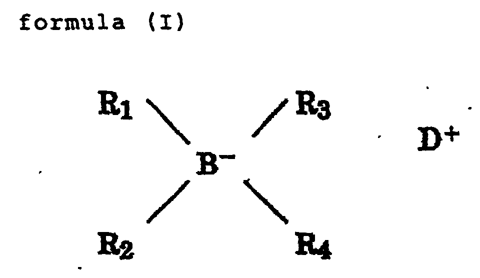 wherein D⁺ represents a cationic dye portion; each of R₁, R₂, R₃ and R₄ represents an alkyl group, an aryl group, an aralkyl group, an alkenyl group, an alkynyl group, a cycloalky group, or an allyl group; and R₁, R₂, R₃ and R₄ may be same as or different from each other.

8. The material for dry-process forming image as claimed in Claim 1, wherein the dye precursor is a substantially colorless compound which has a lactone, lactam, sultone, spiropyran, ester or amide structure in the partial skeleton thereof.

9. The material for dry-process forming image as claimed in Claim 1, wherein the developer is a clay, a phenol resin or a salt thereof with a polyvalent metal, an aromatic carboxylic acid or a salt thereof with a polyvalent metal, or a mixture thereof.

10. A method for dry-process forming image comprising an image-wise exposure to a material for dry-process forming image and a development by an application of pressure; wherein the material for dry-process forming image comprises a support, a photo-sensitive and pressure-sensitive recording layer, a resin layer and an adhesive sheet; wherein the photo-sensitive and pressure-sensitive recording layer, the resin layer and the adhesive sheet are ranged on and from the support; wherein the photo-sensitive and pressure-sensitive recording layer is in a state of single layer or multiple layers; wherein the photo-sensitive and pressure-sensitive recording layer at least contains a microcapsule and a developer; wherein the microcapsule has a photo-curing compound, photoinitiator and a dye precursor in the inner phase thereof; wherein at least one of group consisting of the support and the adhesive sheet is transparent; and wherein the image-wise exposure is conducted from the transparent side.

11. The method for dry-process forming image as claimed in claim 10, wherein the support is a transparent support and the adhesive sheet is an opaque adhesive sheet or a transparent adhesive sheet.

12. The method for dry-process forming image as claimed in Claim 10, wherein the support is an opaque support and the adhesive sheet is a transparent adhesive sheet.

13. The method for dry-process forming image as claimed in Claim 10, wherein the resin of the resin layer is a water-soluble resin or a water-dispersed resin.

14. The method for dry-process forming image as claimed in Claim 10, wherein the photo-curing compound is a radical addition-polymerizable substance.

15. The method for dry-process forming image as claimed in Claim 10, wherein the photoinitiator is an initiator which absorbs a chemical ray and generates a free radical being capable of initiating a free radical polymerization of a polymerizable or crosslinkable compound.

16. The method for dry-process forming image as claimed in Claim 15, wherein the photoinitiator is a compound represented by the following formula (I); 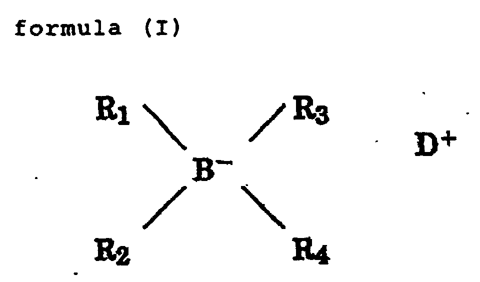 wherein D⁺ represents a cationic dye portion; each of R₁, R₂, R₃ and R₄ represents an alkyl group, an aryl group, an aralkyl group, an alkenyl group, an alkynyl group, a cycloalkyl group, or an allyl group; and R₁, R₂, R₃ and R₄ may be same as or different from each other.

17. The method for dry-process forming image as claimed in Claim 10, wherein the dye precursor is a substantially colorless compound which has a lactone, lactam, sultone, spiropyran, ester or amide structure in the partial skeleton thereof.

18. The method for dry-process forming image as claimed in Claim 10, wherein the developer is a clay, a phenol resin or a salt thereof with a polyvalent metal, an aromatic carboxylic acid or a salt thereof with a polyvalent metal, or a mixture of thereof.
